# EUROPEAN PATENT APPLICATION

(11) **EP 4 718 996 A1**
(43) Date of publication of application: **01.04.2026**
(21) Application number: 25201782.7
(22) Date of filing: 12.09.2025
(51) Int. Cl.: H10D 84/80, H10D 30/60, H10W 10/10, H10W 10/30, H10W 10/17, H10W 10/00

(54) **INTEGRATED ELECTRONIC DEVICE WITH AN IMPROVED DECOUPLING OF THE SEMICONDUCTIVE WELLS AND RELATED MANUFACTURING PROCESS**

(30) Priority: 25.09.2024 IT 202400021344
(71) Applicant: STMicroelectronics International N.V., 1228 Plan-les-Ouates, Geneva (CH)
(72) Inventor: SICURELLA, Giovanni, 95125 CATANIA (IT); RICOTTI, Giulio, 27043 BRONI (PV) (IT)
(74) Representative: Studio Torta S.p.A.

(57) **Abstract**

Integrated electronic device (60) including: an upper semiconductive region (22) of a first conductivity type; a first and a second semiconductive well (24,30) of a second conductivity type, which extend in the upper semiconductive region (22); a first electronic component (2) formed in the first semiconductive well (24) and including a terminal (M2) coupled to the first semiconductive well (24); and a second electronic component (38) formed in the second semiconductive well (30) and including a terminal (M3), which is coupled to the second semiconductive well (30) and receives an electrical signal. The electronic device also includes a decoupling structure (48,62,149) interposed between the first and the second semiconductive wells (24,30) and including: a third semiconductive well (62) of the second conductivity type, which is arranged facing the second semiconductive well (30); a biasing terminal (Tₚ) coupled to the third semiconductive well (62) and set to a supply voltage (VIN); and a barrier structure (149), which is arranged facing the first semiconductive well (24) and comprises a separation semiconductive region (49) of the first conductivity type and a dielectric structure (46,68) which laterally delimits the separation semiconductive region (49). Figure 5

## Description

### Technical Field

The present invention refers to an integrated electronic device, which comprises at least one pair of semiconductive wells and exhibits an improved decoupling of the semiconductive wells; furthermore, the present invention refers to the related manufacturing process.

### Background

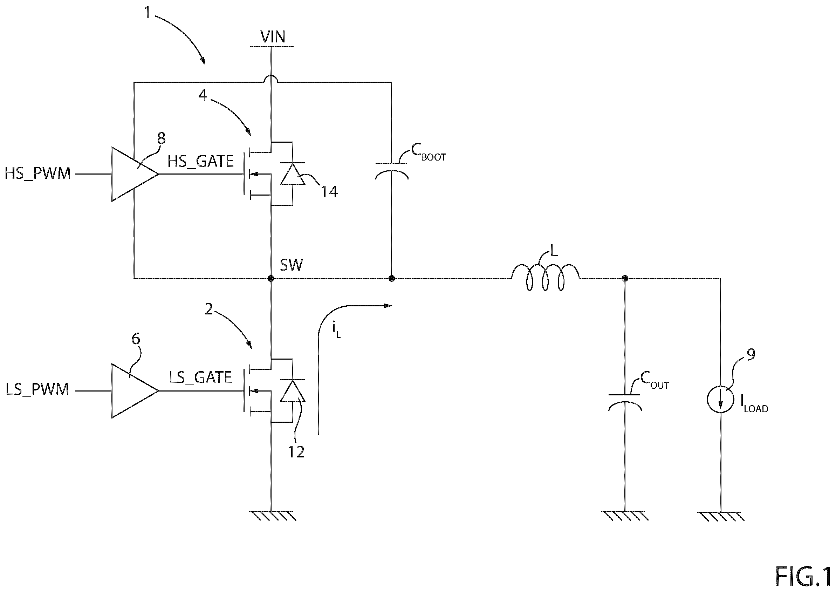

As is known, electronic circuits are available nowadays, such as for example the converter 1 shown in Figure 1, which is a half-bridge buck DC-DC converter.

In detail, the converter 1 comprises a first and a second transistor 2, 4, which are enrichment N-channel MOSFET transistors, have the respective body terminals connected to the respective source terminals and are also known as the low-side transistor and the high-side transistor, respectively.

The drain terminal of the first transistor 2 is connected to the source terminal of the second transistor 4, so as to form a node SW. The source terminal of the first transistor 2 is connected to ground, while the drain terminal of the second transistor 4 is set to a supply voltage VIN, which is generated by an external power supply (not shown) to the converter 1.

The converter 1 also comprises a first and a second driving stage 6, 8, which receive at input a signal LS_PWM and a signal HS_PWM, respectively, which are generated by a control unit (not shown), and have outputs connected to the gate terminals of the first and the second transistors 2, 4, respectively. In this manner, the switching on and off of the first and the second transistors 2, 4 are controlled by a signal LS_GATE and a signal HS_GATE, respectively, which are logic signals generated on the outputs of the first and the second driving stages 6, 8 and have voltage values such that, when the signal LS_GATE is equal to '1' or '0', the first transistor 2 is respectively on or off, and when the signal HS_GATE is equal to '1' or '0', the second transistor 4 is, respectively, on or off. Furthermore, the first and the second transistors 2, 4 are switched on/off alternately, with a frequency known as the switching frequency, and avoiding that the first and the second transistors 2, 4 are simultaneously on.

As shown again in Figure 1, the first and the second transistors 2, 4 comprise respective body diodes 12, 14, each of which has the respective cathode terminal connected to the drain terminal of the corresponding transistor and has the respective anode terminal connected to the source terminal of the corresponding transistor.

Furthermore, in use the converter 1 is coupled to a bootstrap capacitor C_{BOOT} (for example, of the electrolytic type), to an inductor L and an output capacitor C_{OUT} (for example, of the electrolytic type), as well as to a load 9 that draws a current I_{LOAD}. In particular, the terminals of the bootstrap capacitor C_{BOOT} are connected to the positive power supply terminal of the second driving stage 8 and to the node SW, respectively; the negative power supply terminal of the second driving stage 8 is also connected to the node SW. The first and the second terminals of the inductor L are connected to the node SW and to a first terminal of the output capacitor C_{OUT}, respectively, whose second terminal is connected to ground. The second terminal of the inductor L and the first terminal of the output capacitor C_{OUT} are also connected to a first terminal of the load 9, whose second terminal is connected to ground.

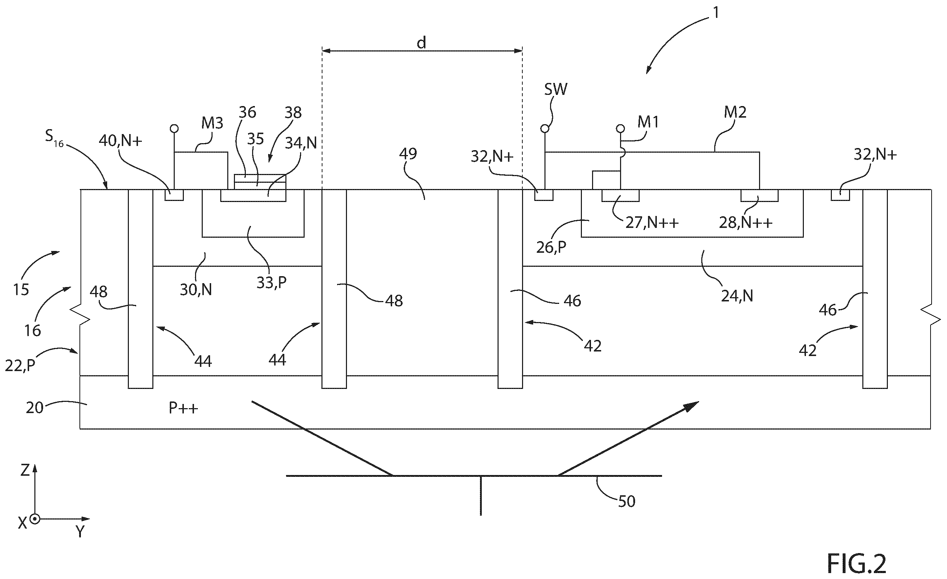

As shown in Figure 2, the converter 1 is formed in a semiconductive die 15, which comprises a semiconductor body 16, which is formed for example by silicon and includes a substrate 20, which has a P++ type doping (for example, with resistivity per square comprised between 100 Ω/sq and 300 Ω/sq), and an epitaxial layer 22, which has a P- type doping (for example, with resistivity per square comprised between 5740 Ω/sq and 7395 Q/sq) and overlies the substrate 20, in direct contact.

The epitaxial layer 22 is delimited at the top by a front surface S₁₆, which is approximately parallel to the XY plane of an orthogonal reference system XYZ and delimits at the top the semiconductor body 16; furthermore, the semiconductor body 16 comprises a first well 24 with N-type doping, which extends in the epitaxial layer 22 starting from the front surface S₁₆, and which is hereinafter referred to as the component well 24.

The component well 24 has for example a resistivity per square comprised between 414 Ω/sq and 2710 Q/sq. Furthermore, the component well 24 houses the first transistor 2, which is formed by: a body semiconductive region 26, which has a P-type doping (for example, with resistivity per square comprised between 5740 Ω/sq and 7395 Q/sq) and extends in the component well 24, starting from the front surface S₁₆; a source semiconductive region 27 and a drain semiconductive region 28, which have N++ type doping (for example, with resistivity per square comprised between 80 Ω/sq and 200 Q/sq), extend in the body semiconductive region 26 starting from the front surface S₁₆ and are laterally spaced. Although not shown in Figure 2, the first transistor 2 also comprises a gate conductive region and a gate dielectric region, which extend above the front surface S₁₆. In general, in Figure 2, the representation of the source semiconductive region 27 and the drain semiconductive region 28 is purely qualitative; in this regard, the first transistor 2 may for example be a DMOS-type transistor.

Furthermore, as shown schematically in Figure 2, the source semiconductive region 27 is electrically connected to the body semiconductive region 26 by means of a first metallization M1 (shown only in Figure 2, as an electrical equivalent), which contacts both the source semiconductive region 27 and the body semiconductive region 26 with which it forms corresponding ohmic contacts; furthermore, in an optional manner (not shown in Figure 2), the first metallization M1 may contact, instead of the body semiconductive region 26, an enriched semiconductive region (not shown), which has an N+ type doping and extends in the body semiconductive region 26 starting from the front surface S₁₆. The first metallization M1 forms a terminal adapted to be connected to ground, in use; furthermore, although not shown, in use the substrate 20 is also connected to ground.

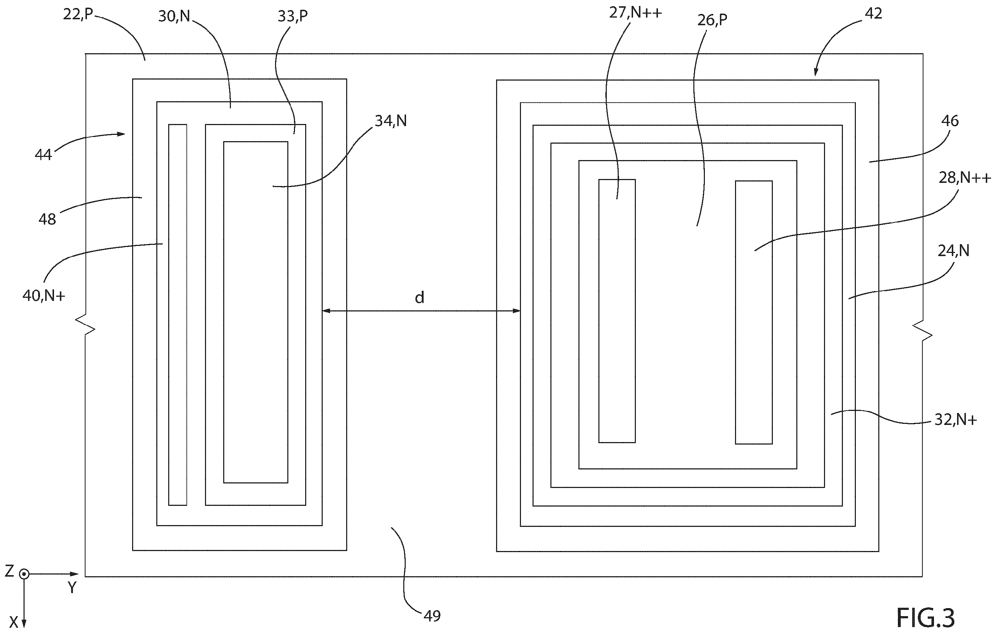

The semiconductor body 16 also comprises a first enriched region 32, which has an N+ type doping and extends within the component well 24 starting from the front surface S₁₆, at a distance from the body semiconductive region 26; for example, the first enriched region 32 has a resistivity per square comprised between 80 Ω/sq and 200 Q/sq. As visible in Figure 3, the first enriched region 32 has, for example, the shape of a frame and laterally surrounds the body semiconductive region 26. A second metallization M2 (shown only in Figure 2, as an electrical equivalent) contacts both the first enriched region 32 and the drain semiconductive region 28, with which it forms corresponding ohmic contacts; consequently, the second metallization M2 is electrically connected to the component well 24 in an ohmic manner, i.e. without forming rectifying contacts. The second metallization M2 forms the drain terminal of the first transistor 2, therefore it forms the node SW.

In practice, the first transistor 2 is formed partially within the component well 24. A better insulation of the first transistor 2 is thus obtained with respect to the other electronic components integrated in the semiconductive die 15. In this regard, although not shown, the second transistor 4 may also be integrated in a corresponding N-type semiconductive well (not shown); more generally, the entire converter 1 may be integrated in the semiconductive die 15. Electronic components integrated in different wells may have different voltage domains. Furthermore, the electrical connection between the drain semiconductive region 28 and the component well 24, through the second metallization M2, is typical of the integration of transistors of the so-called non-insulated drain type and is characterized by a reduced use of manufacturing masks and low costs.

As shown again in Figure 2, the semiconductor body 16 further comprises a second well 30 with N-type doping (for example, with a resistivity per square comprised between 414 Ω/sq and 2710 Ω/sq), which extends in the epitaxial layer 22 starting from the front surface S₁₆, and which is hereinafter referred to as the circuit well 30.

In greater detail, the component well 24 and the circuit well 30 are laterally spaced and have, for example, approximately a same thickness, measured along the Z axis. In particular, as also visible in Figure 3, the component well 24 and the circuit well 30 are arranged approximately along the Y axis and are spaced by a distance d.

An intermediate region 33, which has a P-type doping, extends within the circuit well 30, starting from the front surface S₁₆. A further semiconducive region, which is hereinafter referred to as the capacitor semiconductive region 34, extends within the intermediate region 33, starting from the front surface S₁₆. The capacitor semiconductive region 34 has an N-type doping.

As shown qualitatively again in Figure 2, a dielectric region 35 (shown only in Figure 2) extends above the capacitor semiconductive region 34, in direct contact with the latter. The dielectric region 35 therefore extends above the front surface S₁₆. Furthermore, a conductive region 36 (shown only in Figure 2), formed for example by polysilicon, extends above the dielectric region 35. In practice, the capacitor semiconductive region 34, the dielectric region 35 and the conductive region 36 form a capacitor 38 (shown only in Figure 2), which for example may be a capacitor of one of the voltage regulators (not shown) that form the converter 1 and supply for example the first and the second driving stages 6, 8; alternatively, the capacitor 38 may be a capacitor of a charging circuit (not shown) of the bootstrap capacitor C_{BOOT}.

The semiconductor body 16 also comprises a second enriched region 40, which has an N+ type doping and extends within the circuit well 30 starting from the front surface S₁₆, at a distance from the intermediate region 33; for example, the second enriched region 32 has a resistivity per square comprised between 80 Ω/sq and 200 Q/sq. As visible in Figure 3, the second enriched region 40 has for example an elongated shape parallel to the X axis. A third metallization M3 (shown only in Figure 2, as an electrical equivalent) contacts the second enriched region 40 and the capacitor semiconductive region 34, with which it forms corresponding ohmic contacts; the third metallization M3 is therefore electrically connected to the circuit well 30 in an ohmic manner and forms a terminal of the capacitor 38, which in use receives a corresponding electrical signal. Although not shown, the intermediate region 33 is instead connected to ground.

As visible again in Figures 2 and 3, a first and a second trench 42, 44 extend through the semiconductor body 16, starting from the front surface S₁₆ and with a depth (measured parallel to the Z axis) approximately equal, such depth being greater than the thickness of the component well 24 and the circuit well 30; in particular, the depth is such that the first and the second trenches 42, 44 traverse the epitaxial layer 22 and extend in part within the substrate 20.

The first trench 42 has the shape of a frame, in top view, and laterally surrounds the component well 24. The second trench 44 has the shape of a frame, in top view, and laterally surrounds the circuit well 30. Furthermore, a first and a second dielectric structure 46, 48, respectively, extend within the first and the second trenches 42, 44 . Consequently, an upper portion of the first dielectric structure 46 laterally surrounds the component well 24, in direct contact, while a lower portion of the first dielectric structure 46 extends through part of the substrate 20. Similarly, an upper portion of the second dielectric structure 48 laterally surrounds the circuit well 30, in direct contact, while a lower portion of the second dielectric structure 48 extends through part of the substrate 20.

In practice, the first and the second trenches 42, 44, and therefore also the first and the second dielectric structures 46, 48, are spaced from each other, in particular parallel to the Y axis. In this manner, the first and the second dielectric structures 46, 48 laterally delimit a portion of epitaxial layer 22, which is hereinafter referred to as the separation semiconductive region 49. In particular, the separation semiconductive region 49 faces the front surface S₁₆ and is laterally delimited by corresponding portions of the first and the second dielectric structures 46, 48, which extend parallel to the XZ plane.

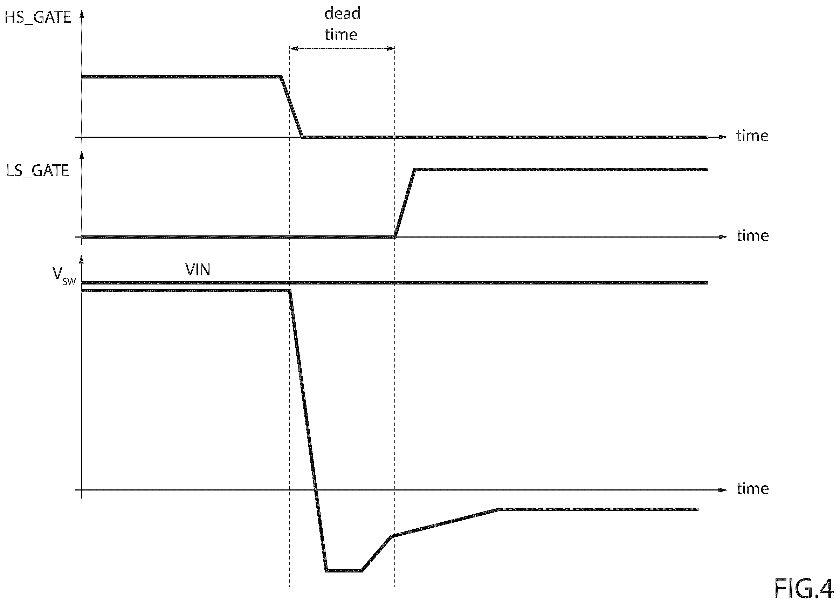

This having been said, during operation of the converter 1, the following occurs, described with reference to Figure 4, and with the premise that, as visible in Figure 2, the circuit well 30, the component well 24 and the substrate 20 (and the portions of epitaxial layer 22 arranged below the circuit well 30 and the component well 24) form a parasitic bipolar transistor 50 of the NPN type (shown with an equivalent electrical symbol in Figure 2).

Assuming that the converter 1 is in a so-called charging phase of the inductor L (also known as T_{ON}), and therefore assuming that the signal LS_GATE and the signal HS_GATE are respectively equal to '0' and '1', and therefore assuming that the first and the second transistors 2, 4 are respectively off and on, a current i_{L} flows into the inductor L, which is supplied by the second transistor 4. The voltage on the node SW, indicated by V_{SW}, is equal to about the supply voltage VIN.

Subsequently, following the switching off of the second transistor 4 and waiting for the successive switching on of the first transistor 2, that is during the time interval wherein the signal LS_GATE and the signal HS_GATE are both equal to '0' (this time interval being also known as dead time), the current i_{L} flows through the body diode 12 of the first transistor 2, as shown in Figure 1. For this reason, during the dead time it occurs that the voltage V_{SW} drops below zero, to allow the current i_{L} to flow through the body diode 12 of the first transistor 2.

Following the switching from "0' to '1' of the signal LS_GATE, therefore during the so-called T_{OFF}, the switching on of the first transistor 2 occurs, in such a way that the current i_{L} may flow through the first transistor 2 for the entire duration of the so-called T_{OFF}, that is for the time period wherein the first and the second transistors 2, 4 are respectively on and off. Consequently, even during this time period the voltage V_{SW} remains, albeit slightly, negative.

Since during the dead time and during the T_{OFF} the voltage V_{SW} is negative, also the component well 24 is at a lower voltage than the ground. This causes the parasitic bipolar transistor 50 to switch on, since in the component well 24 electrons are present that propagate towards the substrate 20, where they are only partially drawn by the holes present therein; the electrons that do not recombine in the substrate 20 therefore reach the circuit well 30. In other words, the parasitic bipolar transistor 50 is flown through by a parasitic current.

Since the circuit well 30 is not electrically connected to a voltage generator, but is connected to the capacitor semiconductive region 34 of the capacitor 38, and therefore is connected to a signal path, the parasitic current that is drawn from the circuit well 30 may cause a malfunction, since it generates, for example, noise (in the present example, on the capacitor 38). In particular, the parasitic current may cause an unwanted discharge of the capacitor 38. Similarly, disturbances may be introduced on the electrical signals present in the circuit well 30, such as for example disturbances with a frequency equal to the switching frequency of the converter **1.**

In general, the same problem also occurs in the event that a component other than the capacitor 38 is formed, within the circuit well 30, if the circuit well 30 is in any case connected to a node having a signal thereon, therefore to a node that is not able to maintain its own voltage independently of the current that is drained from the circuit well 30. Furthermore, even in the event that the circuit well 30 is electrically connected to the output, for example, of a voltage regulator, therefore to a component that has a certain capacity to maintain a voltage, the parasitic current might cause unwanted variations in the current supplied by the voltage regulator; furthermore, if the parasitic current exceeded the regulation capacity of the voltage regulator, a voltage drop would also occur.

In order to reduce the amount of the parasitic current, the distance d may be increased, i.e. the width of the separation semiconductive region 49, so as to reduce the gain of the parasitic transistor 50. In addition, further trenches, and dielectric structures thereof may be interposed, between the component well 24 and the circuit well 30, so as to form a succession of separation semiconductive regions, each of which is laterally delimited by a corresponding pair of dielectric structures. These solutions allow the impact of the parasitic current to be reduced, however, to be effective, they require a high area consumption.

### Summary

The aim of the present invention is therefore to provide an integrated electronic device that overcomes at least in part the drawbacks of the prior art.

According to the present invention, an integrated electronic device and a manufacturing process are provided as defined in the attached claims.

### Brief Description of the Figures

For a better understanding of the present invention, embodiments thereof are now described, purely by way of nonlimiting example, with reference to the attached drawings, wherein:
- Figure 1 shows a circuit diagram of an electrical circuit;
- Figure 2 schematically shows a cross-section of a portion of a converter forming part of the electrical circuit shown in Figure 1;

- Figure 3 schematically shows a top view with portions removed of the converter portion shown in Figure 2;
- Figure 4 shows trends over time of electrical quantities present in the electrical circuit shown in Figure 1;
- Figure 5 schematically shows a cross-section of a portion of an embodiment of the present integrated electronic device; and
- Figure 6 schematically shows a top view with portions removed of the integrated electronic device portion shown in Figure 5.

### Description of Embodiments

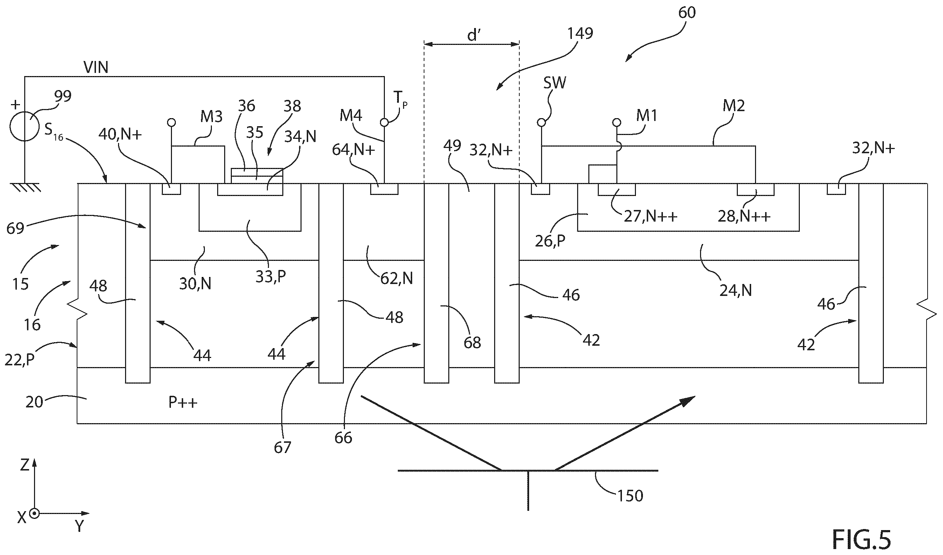

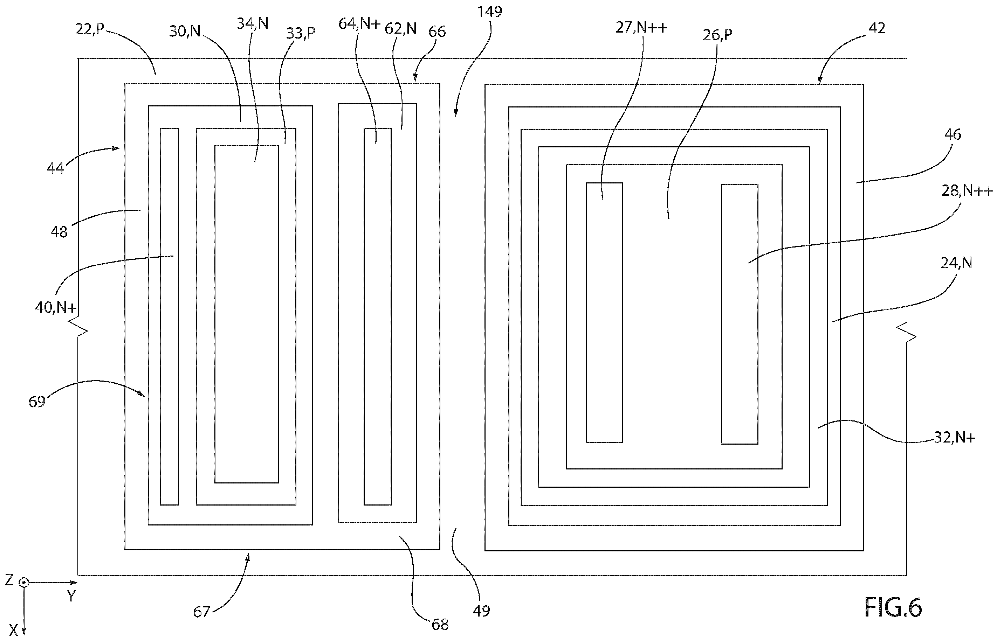

Figures 5 and 6 show an integrated electronic device 60, which is now described with reference to the differences with respect to what is shown in Figures 2 and 3; elements already shown in Figures 2 and 3 are indicated with the same reference signs, unless otherwise specified. The present description therefore refers, purely by way of example, to the case in which the first transistor 2 is formed in the component well 24, and the capacitor 38 is formed in the circuit well 30, although the present solution may also find application in cases in which the component well 24 and the circuit well 30 house different components, as also explained below.

In detail, the integrated electronic device 60 comprises a further semiconductive well 62, which is hereinafter referred to as the sacrificial well 62.

The sacrificial well 62 has an N-type doping, for example with a resistivity per square comprised between 414 Ω/sq and 2710 Ω/sq. In particular, the sacrificial well 62 extends in the epitaxial layer 22 starting from the front surface S₁₆; purely by way of example, the sacrificial well 62 may have, for example, the same thickness as the component well 24 and the circuit well 30.

The semiconductor body 16 also comprises a third enriched region 64, which has an N+ type doping and extends within the sacrificial well 62 starting from the front surface S₁₆; for example, the third enriched region 64 has a resistivity per square comprised between 80 Ω/sq and 200 Q/sq. As visible in Figure 6, the third enriched region 64 has for example an elongated shape parallel to the X axis. A fourth metallization M4 (shown only in Figure 5, as an electrical equivalent) contacts the third enriched region 64, with which it forms a corresponding ohmic contact, and forms a corresponding biasing terminal T_{P}. The fourth metallization M4 is electrically connected to the sacrificial well 62 in an ohmic manner.

As visible again in Figures 5 and 6, a third trench 66 extends through the semiconductor body 16, starting from the front surface S₁₆ and with a depth for example equal to the depth of the first and the second trenches 42, 44, therefore with a depth greater than the thickness of the sacrificial well 62. In particular, the third trench 66 traverses the epitaxial layer 22 and extends in part within the substrate 20.

In top view, the third trench 66 has the shape of a "C", with ends arranged facing the second trench 44; in particular, the ends of the third trench 66 communicate with the second trench 44, so as to form a single trench structure 67 having a figure-eight shape, in top view.

In greater detail, the sacrificial well 62 extends between a portion of the second trench 44 and the third trench 66, which form an annular trench portion.

The third trench 66 is filled by a third dielectric structure 68, which therefore also has the shape of a "C" in top view and has ends that contact the second dielectric structure 48, with which it forms a single overall dielectric structure 69, which fills the trench structure 67 and also has a figure-eight shape, in top view.

In practice, the sacrificial well 62 is laterally surrounded, in direct contact, by the third dielectric structure 68 and by a portion of the second dielectric structure 48 arranged facing the sacrificial well 62. More in particular, an upper portion of the third dielectric structure 68 laterally contacts with the sacrificial well 62, while a lower portion of the third dielectric structure 68 extends through part of the substrate 20.

Furthermore, the separation semiconductive region (again indicated by 49) is laterally delimited by a portion of the third dielectric structure 68 parallel to the XZ plane, as well as by the aforementioned portion of the first dielectric structure 46 that extends parallel to the XZ plane.

In use, the biasing terminal T_{P} is set to the supply voltage VIN, for example by connecting it to a voltage generator 99 (schematically shown in Figure 5). Consequently, the following occurs.

The circuit well 30 and the sacrificial well 62 form the collector of the parasitic bipolar transistor (here indicated by 150); the base and the emitter of the parasitic bipolar transistor 150 are formed respectively by the substrate 20 and the first well 24. The parasitic bipolar transistor 150 thus differs from what has been shown in Figure 2 because its collector is formed by the sacrificial well 62, which, as mentioned, is electrically connected to the biasing terminal T_{P}, which is set to the supply voltage VIN. Consequently, when the voltage V_{SW} is negative, the parasitic bipolar transistor 150 switches on, however it drains current mainly from the sacrificial well 62, rather than from the circuit well 30; in this manner, the trend of the voltage on the capacitor 38 is not influenced by the trend of the voltage V_{SW}; equally, the electrical decoupling between the component well 24 and the circuit well 30 has been improved. As regards instead the sacrificial well 62, it essentially remains at the supply voltage VIN, thanks to the presence of the voltage generator 99, regardless of the intensity of the current drained by the parasitic bipolar transistor 150.

Furthermore, the separation semiconductive region 49 forms, together with the portions of the first and the third dielectric structures 46, 68 that delimit it, a barrier 149, which is interposed, along the Y axis, between the component well 24 and the sacrificial well 62, which in turn is interposed between the barrier 149 and the circuit well 30, from which it is separated by a corresponding portion of the second dielectric structure 48. In practice, the barrier 149 and the sacrificial well 62 form a decoupling structure, which is interposed between the component well 24 and the circuit well 30; furthermore, the barrier 149 is arranged facing the component well 24, while the sacrificial well 62 is arranged facing the circuit well 30.

The barrier 149 has for example an approximately invariant section parallel to the X axis and has a width d', measured parallel to the Y axis. The width d' may be reduced with respect to the distance d shown in Figure 2, since the effectiveness of the decoupling between the component well 24 and the circuit well 30 is ensured by the presence of the sacrificial well 62; the presence of the barrier 149 allows in any case to reduce the intensity of the current drained by the parasitic bipolar transistor 150, and therefore to reduce consumptions.

The advantages that the present integrated electronic device affords are clear from the preceding description, in particular with regard to the improved decoupling between the component well 24 and the circuit well 30, thanks to the use of the sacrificial well 62, which is set to a voltage for example equal to the supply voltage VIN, in order to provide the current that flows into the parasitic bipolar transistor 150 in the place of the circuit well 30.

Finally, it is clear that modifications and variations may be made to the electronic device previously described, without departing from the scope of the present invention, as defined in the attached claims.

As previously explained, any electronic component, other than the first transistor 2, may be formed within the component well 24 and above the component well 24. Similarly, any electronic component, other than the capacitor 38, may also be formed within and above the circuit well 30; for example, an NMOS transistor may be formed and/or a so-called CMOS well and/or a well having a diffuse resistor formed therein may extend within the circuit well 30.

For example, multiple component wells, as well as multiple circuit wells, may be present. The wells may also have different depths; the trenches may also have different depths. Furthermore, the wells may have different shapes, in a top view, than described.

The first, the second and the third dielectric structures 46, 48, 68 may have any composition; for example, they may be entirely formed by dielectric material, or they may be formed by polysilicon surrounded by dielectric material.

Furthermore, the trenches that house the first, the second and the third dielectric structures 46, 48, 68 may have a different depth than described; for example, such trenches may extend only in an upper portion of the epitaxial layer 22, without partially penetrating the substrate 20.

The semiconductor body 16 may have a different structure than described. For example, a second epitaxial layer may be present. Furthermore, the separation semiconductive region 49 may be formed, instead of a portion of the epitaxial layer 22, by a corresponding well with P-type doping.

Finally, portions of electronic components (e.g., of the second transistor 4) may extend within the sacrificial well 62.

## Claims

1. An integrated electronic device (60) comprising:
- a semiconductive substrate (20) of a first conductivity type;
- an upper semiconductive region (22) of the first conductivity type, which is arranged above the semiconductive substrate (20) and is delimited by a front surface (S₁₆);
- a first semiconductive well (24) of a second conductivity type, which extends in the upper semiconductive region (22) starting from the front surface (S₁₆);
- a second semiconductive well (30) of the second conductivity type, which extends in the upper semiconductive region (22) starting from the front surface (S₁₆) and is spaced from the first semiconductive well (30);
- a first electronic component (2) formed at least in part within the first semiconductive well (24) and including a respective terminal (M2), which is coupled in an ohmic manner to the first semiconductive well (24); and
- a second electronic component (38) formed at least in part within the second semiconductive well (30) and including a respective terminal (M3), which is coupled in an ohmic manner to the second semiconductive well (30) and is configured to receive, in use, a respective electrical signal;
said integrated electronic device (60) further comprising a decoupling structure (48,62,149) interposed between the first and the second semiconductive well (24,30) and comprising:
- a third semiconductive well (62) of the second conductivity type, which extends in the upper semiconductive region (22) starting from the front surface (S₁₆) and is arranged facing the second semiconductive well (30);
- a biasing terminal (Tₚ) coupled in an ohmic manner to the third semiconductive well (62) and configured to be set, in use, to a supply voltage (VIN); and
- a barrier structure (149), which is arranged facing the first semiconductive well (24) and comprises a separation semiconductive region (49) of the first conductivity type, which faces the front surface (S₁₆), and a barrier dielectric structure (46,68) which extends in the upper semiconductive region (22) starting from the front surface (S₁₆) and laterally delimits the separation semiconductive region (49).

2. The integrated electronic device according to claim 1, further comprising a well dielectric structure (48,68) which extends in the upper semiconductive region (22) starting from the front surface (S₁₆) and laterally surrounds, in direct contact, the third semiconductive well (62).

3. The integrated electronic device according to claim 2, wherein the well dielectric structure (48,68) separates the third semiconductive well (62) from the second semiconductive well (30).

4. The integrated electronic device according to claim 2 or 3, further comprising a component dielectric structure (46), which extends in the upper semiconductive region (22) starting from the front surface (S₁₆) and laterally surrounds, in direct contact, the first semiconductive well (24).

5. The integrated electronic device according to claim 4, wherein the barrier dielectric structure (46,68) comprises a portion of the well dielectric structure (48,68) and a portion of the component dielectric structure (46).

6. The integrated electronic device according to any of the preceding claims, wherein the first and second semiconductive wells (24,30) are arranged along a direction (Y); and wherein the third semiconductive well (62) is interposed, along said direction (Y), between the second semiconductive well (30) and the barrier structure (149); and wherein, along said direction (Y), the barrier structure (149) is interposed between the third semiconductive well (62) and the first semiconductive well (24).

7. The integrated electronic device according to any of the preceding claims, further comprising:
- a first, a second and a third enriched semiconductive region (32,40,64) of the second conductivity type, which extend respectively within the first, the second and the third semiconductive well (24,40,62), starting from the front surface (S₁₆), and have doping levels respectively higher than the doping levels of the first, the second and the third semiconductive well (24,40,62);
- a first component conductive region (M2), a second component conductive region (M3) and a well conductive region (M4), which extend above the front surface (S₁₆), the first component conductive region (M2) forming the terminal of the first electronic component (2) and contacting the first enriched semiconductive region (32), the second component conductive region (M3) forming the terminal of the second electronic component (38) and contacting the second enriched semiconductive region (40), the well conductive region (M4) forming the biasing terminal (Tₚ) and contacting the third enriched semiconductive region (64).

8. The integrated electronic device according to any of the preceding claims, wherein the first and the second conductivity types are respectively a P-type conductivity and an N-type conductivity.

9. The integrated electronic device according to any of the preceding claims, wherein the second and third semiconductive wells (30,62) form the collector of a parasitic bipolar transistor (150) of the NPN-type, the base and the emitter of said parasitic bipolar transistor (150) being formed respectively by the semiconductive substrate (20) and the first semiconductive well (24), in such a way that, when the voltage of the first semiconductive well (24) drops below the voltage of the semiconductive substrate (20), the parasitic bipolar transistor (150) is traversed by a current provided by the third semiconductive well (62).

10. An electronic circuit comprising the integrated electronic device (60) according to any of the preceding claims and a voltage generator (99) configured to generate the supply voltage (VIN) and coupled to the biasing terminal (Tₚ).

11. A process for manufacturing an integrated electronic device (60) comprising:
- above a semiconductive substrate (16) of a first conductivity type, forming an upper semiconductive region (22) of the first conductivity type, which is delimited by a front surface (S₁₆);
- forming a first semiconductive well (24) of a second conductivity type, which extends in the upper semiconductive region (22) starting from the front surface (S₁₆);
- forming a second semiconductive well (30) of the second conductivity type, which extends in the upper semiconductive region (22) starting from the front surface (S₁₆) and is spaced from the first semiconductive well (30);
- forming a first electronic component (2) at least in part within the first semiconductive well (24), the first electronic component (2) comprising a respective terminal (M2) coupled in an ohmic manner to the first semiconductive well (24); and
- forming a second electronic component (38) at least in part within the second semiconductive well (30), the second electronic component (38) comprising a respective terminal (M3) coupled in an ohmic manner to the second semiconductive well (30) and configured to receive, in use, a respective electrical signal;
said manufacturing process further comprising forming a decoupling structure (48,62,149) interposed between the first and the second semiconductive well (24,30) and comprising:
- a third semiconductive well (62) of the second conductivity type, which extends in the upper semiconductive region (22) starting from the front surface (S₁₆) and is arranged facing the second semiconductive well (30);
- a biasing terminal (Tₚ) coupled in an ohmic manner to the third semiconductive well (62) and configured to be set, in use, to a supply voltage (VIN); and
- a barrier structure (149), which is arranged facing the first semiconductive well (30) and comprises a separation semiconductive region (49) of the first conductivity type, which faces the front surface (S₁₆), and a barrier dielectric structure (46,68) which extends in the upper semiconductive region (22) starting from the front surface (S₁₆) and laterally delimits the separation semiconductive region (49).

12. The manufacturing process according to claim 11, further comprising forming a well dielectric structure (48,68), which extends in the upper semiconductive region (22) starting from the front surface (S₁₆) and laterally surrounds, in direct contact, the third semiconductive well (62).

13. The manufacturing process according to claim 12, wherein the well dielectric structure (48,68) separates the third semiconductive well (62) from the second semiconductive well (30).

14. The manufacturing process according to claim 12 or 13, further comprising forming a component dielectric structure (46), which extends in the upper semiconductive region (22) starting from the front surface (S₁₆) and laterally surrounds, in direct contact, the first semiconductive well (24); and wherein the barrier dielectric structure (46,68) comprises a portion of the well dielectric structure (48,68) and a portion of the component dielectric structure (46).

15. The manufacturing process according to any of claim 11-14, wherein the first and the second conductivity types are respectively a P-type conductivity and an N-type conductivity, and wherein the second and third semiconductive wells (30,62) form the collector of a parasitic bipolar transistor (150) of the NPN-type, the base and the emitter of said parasitic bipolar transistor (150) being formed respectively by the semiconductive substrate (20) and the first semiconductive well (24), in such a way that, when the voltage of the first semiconductive well (24) drops below the voltage of the semiconductive substrate (20), the parasitic bipolar transistor (150) is traversed by a current provided by the third semiconductive well (62).
